# EUROPEAN PATENT APPLICATION

(11) **EP 4 439 872 A1**
(43) Date of publication of application: **02.10.2024**
(21) Application number: 22897068.7
(22) Date of filing: 25.05.2022
(51) Int. Cl.: H01R 13/642, H01R 13/40

(54) **WIRING STRUCTURE AND ELECTRICAL BOX**

(30) Priority: 25.11.2021 CN 202122958708 U
(71) Applicant: Sungrow Power Supply Co., Ltd., Hefei, Anhui 230088 (CN)
(72) Inventor: SHEN, Zhanliang, Hefei, Anhui 230088 (CN); YU, Yanfei, Hefei, Anhui 230088 (CN); CHEN, Peng, Hefei, Anhui 230088 (CN); LI, Xiaoxun, Hefei, Anhui 230088 (CN)
(74) Representative: Epping - Hermann - Fischer
(86) International application number: PCT/CN2022/094951
(87) International publication number: WO 2023/092969

(57) **Abstract**

The present invention relates to a wiring structure and an electrical box, the wiring structure comprising a first mounting member and a second mounting member, wherein the first mounting member is used for being arranged outside the electrical box, and is provided with a plurality of conductive connectors; the conductive connectors extend into the electrical box to be connected to an internal device; the second mounting member is used for being detachably connected to the first mounting member, and is internally provided with a plurality of conductive fitting members; the conductive fitting members are connected to external cables; the external cables are slidably fitted with the second mounting member in a sealed manner, and the conductive fitting members are used for being connected to the conductive connectors in a fitting manner when the second mounting member is connected to the first mounting member in a fitting manner. The above wiring structure can achieve a fixed connected between a plurality of cables and the electrical box by means of a set of butt-connection structures, i.e. the first mounting member and the second mounting member, has a small size and a compact structure, and can improve the efficiency of plugging and mounting external cables and reduce errors; moreover, each of the conductive fitting members can be individually plugged and unplugged, and the operations are more flexible.

## Description

This application claims the benefit of the priority to Chinese Patent Application No. 202122958708.6, titled "WIRING STRUCTURE AND ELECTRICAL CABINET", filed with the China National Intellectual Property Administration on November 25, 2021, which is incorporated herein by reference in its entirety.

### FIELD

The present application relates to the technical field of electrical equipment, and in particular to a wiring structure and an electrical cabinet.

### BACKGROUND

In the conventional technology, when a direct-current cable of an electrical cabinet, such as an inverter or a combiner box, is connected to the electrical cabinet, each cable needs to be crimped integrally with a cable end terminal, then the cable end terminal is sleeved with an insulation sleeve thereon, to be inserted in a corresponding board end terminal on a board end, which causes the cable connection end has a large volume, resulting in a high cost. The electrical cabinet needs to reserve a large operation space at a connection with each cable to facilitate the plugging and unplugging of the cable, which increases the space requirement for the electrical cabinet. In addition, the electrical cabinet requires connections with multiple cables, with the above wiring structure, each cable can only be plugged and unplugged separately, which is inefficient and error-prone.

### SUMMARY

A first object according to the present application is to provide a wiring structure, so as to reduce the space requirement at a connection between the cable and the electrical cabinet, reduce the cable connection cost of the electrical cabinet, improve the efficiency of disassembly and assembly of the cables and the electrical cabinet, and reduce the probability of errors.

A second object according to the present application is to provide an electrical cabinet including the wiring structure.

In order to achieve the above objects, the following technical solutions are provided according to the present application.

A wiring structure, for connecting an internal device of an electrical cabinet with external cables, including:
a first mounting member configured to be arranged outside the electrical cabinet, where the first mounting member is provided with multiple conductive connectors which extend into the electrical cabinet to be connected with the internal device; and
a second mounting member configured to be detachably connected with the first mounting member, where multiple conductive fitting members are provided in the second mounting member and are connected with the external cables, the external cables are in slidable fit with the second mounting member in a sealed manner, the conductive fitting members are configured to be fitted to and in conduction with the conductive connectors in a case that the second mounting member is connected with the first mounting member.

Preferably, one of the conductive connector and the conductive fitting member is provided with a pin, the other of the conductive connector and the conductive fitting member is provided with a pin hole, and the conductive connector is in conduction with the corresponding conductive fitting member through plug-in fit between the pin and the pin hole.

Preferably, the wiring structure further includes an adapting member, where the conductive connectors are connected to and in conduction with the conductive fitting members through the adapting member.

Preferably, the adapting member includes an adapting terminal and a conductive adapter embedded in the adapting terminal, two ends of the conductive adapter are connected with the corresponding conductive connector and the corresponding conductive fitting member respectively, and the conductive connector is in conduction with the conductive fitting member through the conductive adapter.

Preferably, one of the conductive adapter and the conductive connector is provided with a pin, the other of the conductive adapter and the conductive connector is provided with a pin hole, and the conductive adapter is in conduction with the conductive connector through plug-in fit between the pin and the pin hole; and
one of the conductive adapter and the conductive fitting member is provided with another

pin, the other of the conductive adapter and the conductive fitting member is provided with another pin hole, and the conductive adapter is in conduction with the conductive fitting member through plug-in fit between the another pin and the another pin hole.

Preferably, an anti-dropping position-limiting structure is provided between the conductive fitting member and the conductive adapter, where the anti-dropping position-limiting structure includes an elastic protrusion provided on one of the conductive fitting member and the conductive adapter and a position-limiting groove defined on the other of the conductive fitting member and the conductive adapter, and the elastic protrusion is fitted to the position-limiting groove when the conductive fitting member is in plug-in fit with the conductive adapter.

Preferably, the adapting member includes a contactor, where two ends of the contactor are respectively provided with multiple adapting input ends for connecting with the conductive fitting members and multiple adapting output ends for connecting with the conductive connectors, each adapting output end is electrically connected with at least one of the adapting input ends, each adapting input end is pressed against and fixed to the corresponding conductive fitting member by a rotary switch or a threaded fastener, and each adapting output end is pressed against and fixed to the corresponding conductive connector by a rotary switch or a threaded fastener.

Preferably, the second mounting member is provided with a position-limiting structure cooperating with the adapting member.

Preferably, one adapting output end of the adapting member is correspondingly connected with multiple adapting input ends.

Preferably, the wiring structure further includes an overload-protection device, where the overload-protection device is arranged on each of the external cables; or the overload-protection device is connected between the external cable and the corresponding conductive fitting member; or the overload-protection device is arranged in the adapting member; or the overload-protection device is arranged in the electrical cabinet and is connected with the corresponding conductive connector.

Preferably, the wiring structure further includes a detection device, where the detection device is arranged on each of the external cables; or the detection device is connected between the external cable and the corresponding conductive fitting member; or the detection device is arranged in the adapting member; or the detection device is arranged in the electrical cabinet and is connected with the corresponding conductive connector.

Preferably, the detection device includes at least one of a temperature sensor, a current sensor and a voltage sensor.

Preferably, the wiring structure further includes a weak current output module and a power input module which are connected with the detection device, the weak current output module is configured to output a signal acquired by the detection device, and the power input module is configured to supply power to the detection device.

Preferably, the power input module includes a power circuit which is connected between the external cable and the detection device.

Preferably, the wiring structure further includes an integrated circuit board, where the detection device, the weak current output module and the power input module are arranged on the integrated circuit board; the integrated circuit board is arranged at the external cable, or the integrated circuit board is arranged on the first mounting member and is connected with the conductive connector, or the integrated circuit board is arranged in the electrical cabinet and is connected with the conductive connector, or the integrated circuit board is arranged on the second mounting member and is connected with the conductive fitting member.

Preferably, the conductive connectors are connected with the conductive fitting members in one-to-one correspondence.

Preferably, the conductive connector includes multiple connection input ends and a connection output end, the multiple connection input ends are connected with the connection output end, the multiple connection input ends are in conduction with the conductive fitting member, and the connection output end extends into the electrical cabinet to be connected with the internal device.

Preferably, the first mounting member includes a base which has a groove defined by an annular boss, and the multiple conductive connectors are arranged in the groove; the second mounting member includes a housing which is detachably and sealingly fitted to the base for connection, and the annular boss is covered in the housing.

Preferably, a sealing structure is provided between an end surface of an opening end of the housing and the base; and/or, a sealing structure is provided between an inner wall of the housing and an outer wall of the annular boss.

Preferably, a sealing structure is provided on a surface, in contact with the electrical cabinet, of the base.

Preferably, the first mounting member is detachably connected with the second mounting member by a snap-fit structure and/or a threaded fastener.

Preferably, the snap-fit structure includes:
multiple elastic hooks, which are uniformly provided at one of the first mounting member and the second mounting member circumferentially; and
multiple hook grooves, which are provided in one-to-one correspondence with the elastic hooks and defined at the other of the first mounting member and the second mounting member; where
the elastic hooks cooperate with the hook grooves to detachably connect the first mounting member with the second mounting member.

Preferably, the snap-fit structure includes:
a locking hook, which is rotatably arranged at one of the first mounting member and the second mounting member, where an elastic member is provided between the one of the first mounting member and the second mounting member which is provided with the locking hook and the locking hook; and
a locking pin, which is arranged on the other f the first mounting member and the second mounting member, where the locking hook cooperates with the locking pin under the action of the elastic member to detachably connect the first mounting member with the second mounting member.

Preferably, the threaded fastener includes multiple bolts, the first mounting member is provided with multiple threaded holes, the second mounting member is provided with multiple through holes, and the multiple bolts pass through the multiple through holes and cooperate with the multiple threaded holes to detachably connect the first mounting member with the second mounting member.

Preferably, the threaded fastener includes a threaded sleeve which is rotatably sleeved on the second mounting member, an outer wall of the first mounting member is provided with threads engaged with the threaded sleeve, and the first mounting member is pressed against and fixed to the second mounting member by threaded engagement between the threaded sleeve and the first mounting member.

An electrical cabinet is provided, which includes the wiring structure according to any one of the above solutions.

It can be seen from the above technical solutions that, the wiring structure for connecting the internal device of the electrical cabinet with the external cables is provided according to the present application. The wiring structure includes the first mounting member and the second mounting member, and both the first and second mounting members are made of insulating materials. The first mounting member is configured to be arranged outside the electrical cabinet, and the first mounting member is provided with the multiple conductive connectors which extend into the electrical cabinet to be connected with the internal device. The second mounting member is configured to be detachably connected with the first mounting member, and the multiple conductive fitting members are provided inside the second mounting member and are connected with the external cables, the external cables are in slidable fit with the second mounting members in a sealed manner, the conductive fitting members are configured to be in conduction with the conductive connectors in the case that the second mounting member is connected with the first mounting member. The above wiring structure integrates the multiple conductive connectors into the first mounting member, and integrates the multiple conductive fitting members into the second mounting member, each conductive fitting member is configured to be connected with a cable, so that the multiple cables are fixedly connected with the electrical cabinet by the set of connection structure including the first mounting member and the second mounting member without the need of providing an insulation sleeve at an end of each cable, leading to a small volume and a compact structure, which is beneficial to reducing a space for a cable connection structure of the electrical cabinet, and is beneficial to miniaturizing the electrical cabinet. In addition, the multiple external cables can be assembled into the electrical cabinet simultaneously, which improves the plugging efficiency of the external cables. Meanwhile, in the structure that the multiple external cables are plugged simultaneously, the arrangement of the conductive connectors and the conductive fitting members can achieve a fool-proofing effect to avoid errors. Moreover, each conductive fitting member is slidable relative to the second mounting member through the external cable, which can realize separate plugging and unplugging of each conductive fitting member, making the operation more flexible.

### BRIEF DESCRIPTION OF THE DRAWINGS

For more clearly illustrating the technical solutions of embodiments of the present application or in the conventional technology, drawings referred to for describing the embodiments or the conventional technology will be briefly described hereinafter. Apparently, the drawings in the following description are only some examples of the present application, and for those skilled in the art, other drawings may be obtained based on these drawings without any creative efforts.
FIG. 1 is a top view of an electrical cabinet and a wiring structure thereof according to an embodiment of the present application;
FIG. 2 is a front view of the electrical cabinet and the wiring structure thereof according to the embodiment of the present application;
FIG. 3 is a front view of the wiring structure according to the embodiment of the present application;
FIG. 4 is a right side view of the wiring structure according to the embodiment of the present application;
FIG. 5 is a cross-sectional view of a first type of wiring structure taken along line A-A according to an embodiment of the present application;
FIG. 6 is an exploded view of a second type of wiring structure according to an embodiment of the present application;
FIG. 7 is a cross-sectional view of the second wiring structure taken along line A-A according to an embodiment of the present application;
FIG. 8 is a partially enlarged schematic view of FIG. 7;
FIG. 9 is a cross-sectional view of the second wiring structure taken along line B-B according to the embodiment of the present application,
FGI. 10 is a partially enlarged schematic view of FIG. 9;
FIG. 11 is a cross-sectional partial view of a third type of wiring structure taken along line A-A according to an embodiment of the present application;
FIG. 12 is a partially cross-sectional partial view of a fourth type of wiring structure taken along line A-A according to an embodiment of the present application;
FIG. 13 is a partially cross-sectional partial view of a fifth type of wiring structure taken along line A-A according to an embodiment of the present application;
FIG. 14 is a partially cross-sectional partial view of a sixth type of wiring structure taken along line A-A according to an embodiment of the present application;
FIG. 15 is a schematic view showing the structure of a detachable connection between a first mounting member and a second mounting member of the wiring structure according to an embodiment of the present application;
FIG. 16 is a schematic view showing the structure of another detachable connection between the first mounting member and the second mounting member of the wiring structure according to an embodiment of the present application; and
FIG. 17 is a schematic view showing the structure of still another detachable connection between the first mounting member and the second mounting member of the wiring structure according to an embodiment of the present application.

Reference numerals:

| | | | |
|---|---|---|---|
| 1 | electrical cabinet, | 2 | external cable, |
| 3 | first mounting member, | 4 | second mounting member, |
| 5 | conductive connector, | 6 | conductive fitting member, |
| 7 | rubber sealing ring, | 8 | adapting terminal, |
| 9 | conductive connector, | 9' | conductive connector, |
| 10 | sealing ring, | 11 | sealing ring, |
| 12 | position-limiting stop, | 13 | elastic hook, |
| 14 | hook groove, | 15 | fuse, |
| 16 | detection device, | 17 | locking hook, |
| 18 | locking pin, | 19 | bolt, |
| 20 | threaded sleeve. | | |

### DETAILED DESCRIPTION OF THE EMBODIMENTS

A core according to the present application is to provide a wiring structure, the structural design of the wiring structure can reduce the requirement of the space at a connection between the cables and the electrical cabinet, so as to reduce the cable connection cost of the electrical cabinet, improve the efficiency of disassembly and assembly of the cables and the electrical cabinet, and reduce the probability of errors.

Another core according to the present application is to provide an electrical cabinet including the above wiring structure.

Technical solutions according to the embodiments of the present application will be described clearly and completely as follows in conjunction with the accompany drawings in the embodiments of the present application. It is obvious that the described embodiments are only a part of the embodiments according to the present application, rather than all of the embodiments. All the other embodiments obtained by those skilled in the art based on the embodiments in the present application without any creative work belong to the scope of protection of the present application.

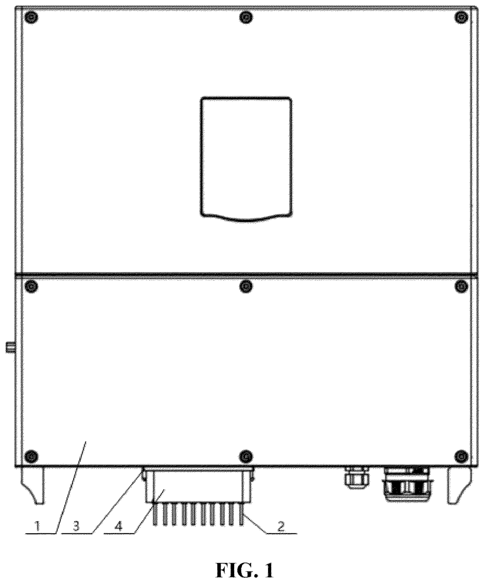

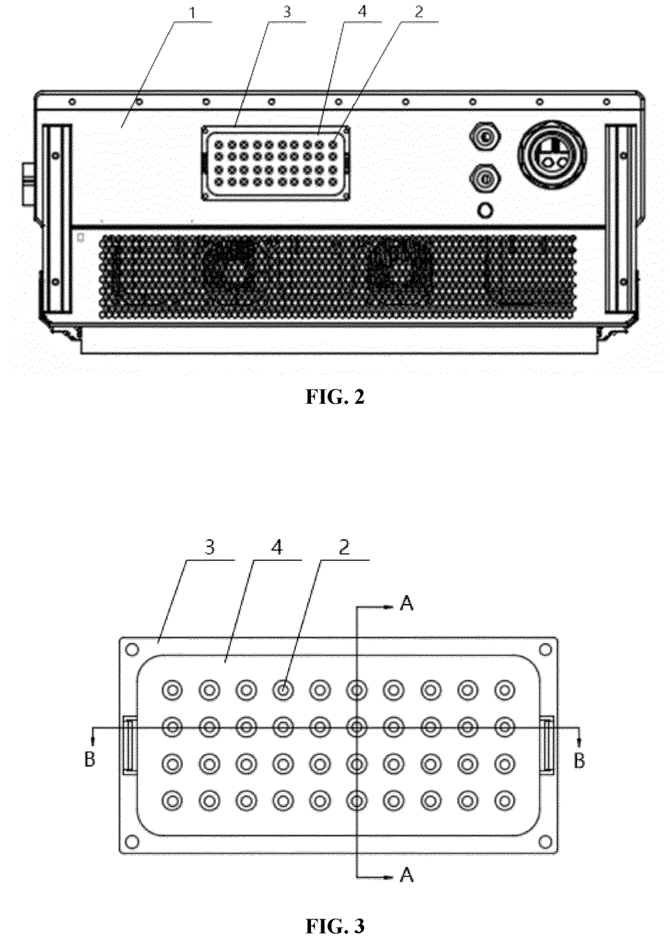

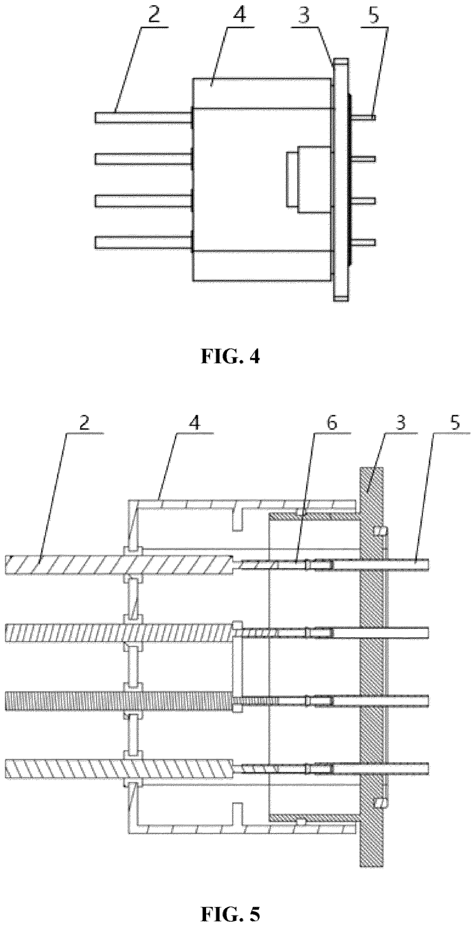

Referring to FIG. 1 to FIG. 5, FIG. 1 is a top view of an electrical cabinet and a wiring structure thereof according to an embodiment of the present application, FIG. 2 is a front view of the electrical cabinet and the wiring structure of the electrical cabinet according to the embodiment of the present application, FIG. 3 is a front view of the wiring structure according to the embodiment of the present application, FIG. 4 is a right side view of the wiring structure according to the embodiment of the present application, and FIG. 5 is a cross-sectional view of a first type of wiring structure taken along line A-A according to an embodiment of the present application.

A wiring structure is provided according to an embodiment of the present application, which is configured to connect an internal device of an electrical cabinet 1 with external cables 2. The wiring structure includes a first mounting member 3 and a second mounting member 4.

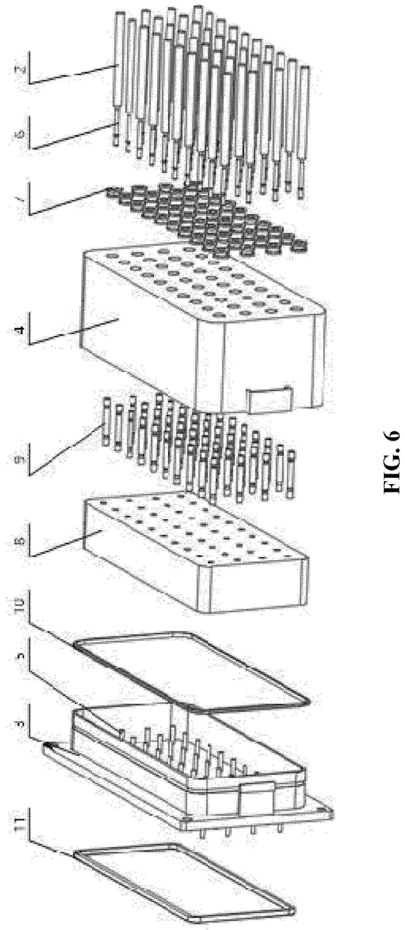

The first mounting member 3 and the second mounting member 4 are both made of insulating materials. The first mounting member 3 is configured to be arranged outside the electrical cabinet 1, and the first mounting member 3 is provided with multiple conductive connectors 5 which extend into the electrical cabinet 1 to be connected with the internal device. The second mounting member 4 is detachably connected with the first mounting member 3, multiple conductive fitting members 6 are provided in the second mounting member 4 and are connected with the external cables 2, and the external cables 2 are in slidable fit with the second mounting member 4 in a sealed manner. As shown in FIG. 6, the second mounting member 4 is provided with multiple through holes, a rubber sealing ring 7 is provided in each of the multiple through holes, and the corresponding external cable 2 is in slidable fit with the rubber sealing ring 7 in a sealed manner. The conductive fitting members 6 are configured to be fitted to and in conduction with the conductive connectors 5 in a case that the second mounting member 4 is connected with the first mounting member 3. The conductive connectors 5 may be in conduction with the conductive fitting members 6 directly or indirectly. The conductive connectors 5 may be in conduction with the conductive fitting members 6 in one-to-one correspondence, in this way, the number of the conductive connectors 5 is the same as the number of the conductive fitting members 6. Alternatively, multiple conductive fitting members 6 may be fitted to and in conduction with one conductive connector 5 or multiple conductive connectors may be fitted to and in conduction with one conductive fitting member 6, that is, the number of the conductive connectors 5 is different from the number of the conductive fitting members 6. Both the conductive connectors 5 and the conductive fitting members 6 may be arranged in a matrix arrangement, an annular multi-layer radial arrangement, or multiple rows staggered arrangement.

It can be seen that, compared with the conventional technology, the wiring structure according to embodiments of the present application integrates the multiple conductive connectors 5 into the first mounting member 3, and integrates the multiple conductive fitting members 6 into the second mounting member 4. Each conductive fitting member 6 is configured to be connected with a cable, so that the multiple cables are fixedly connected with the electrical cabinet 1 by the set of connection structure including the first mounting member 3 and the second mounting member 4, without the need of providing an insulation sleeve at an end of each external cable 2, leading to a small volume and a compact structure, which is beneficial to reducing a space for a cable connection structure of the electrical cabinet 1, and is beneficial to miniaturizing the electrical cabinet 1. In addition, the multiple external cables 2 can be assembled into the electrical cabinet 1 simultaneously, which improves the plugging efficiency of the external cable 2. Meanwhile, in the structure that the multiple external cables 2 are plugged simultaneously, the arrangement of the conductive connectors 5 and the conductive fitting members 6 can achieve a fool-proof effect to avoid errors. Moreover, each conductive fitting member 6 is slidable relative to the second mounting member 4 through the external cable 2, which can realize separate plugging and unplugging of each conductive fitting member 6 making the operation is more flexible.

In an embodiment according to the present application, the conductive connectors 5 are directly fitted to and in conduction with the conductive fitting members 6. As shown in FIG. 5, in this embodiment, a pin is provided on one of the conductive connector 5 and the corresponding conductive fitting member 6, a pin hole is defined on the other one of the conductive connector 5 and the corresponding conductive fitting member 6, and the conductive connector 5 is fitted to and in conduction with the conductive fitting member 6 through plug-in fit between the pin and the pin hole. That is, one of the conductive connector 5 and the corresponding conductive fitting member 6 is provided with a needle-shaped structure at an end thereof, and the other one of the conductive connector 5 and the corresponding conductive fitting member 6 is provided with a hole-shaped structure at an end thereof. Alternatively, one of the conductive connector 5 and the corresponding conductive fitting member 6 may be of a needle-shaped structure as a whole, and the other one of the conductive connector 5 and the corresponding conductive fitting member 6 may be of a hole-shaped structure as a whole. The conductive connectors 5 may be in plug-in fit with the conductive fitting members 6 in one-to-one correspondence as shown in FIG. 5; or in multiple-to-one correspondence, that is, one of the conductive connector 5 and the corresponding conductive fitting member 6 is provided with multiple fitting ends, and the multiple fitting ends are converged at a connecting end for connecting with the external cable 2 or the internal device of the electrical cabinet. Specifically, in an embodiment of the present application, the conductive connector 5 includes multiple connection input ends and a connection output end, the connection input ends are connected with the connection output end, the connection input ends are in conduction with the conductive fitting member 6, and the connection output end extends into the electrical cabinet 1 to be connected with the internal device.

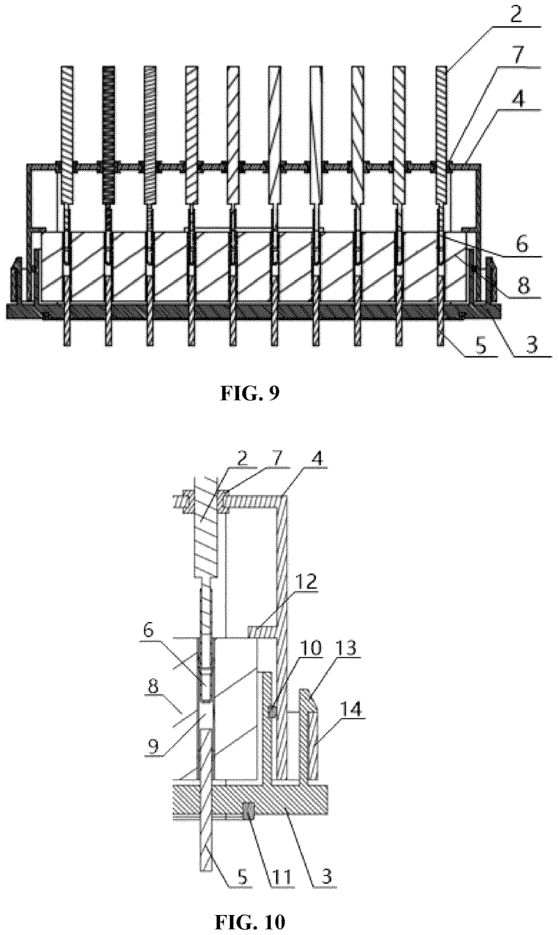

Certainly, the conductive connectors 5 may be indirectly fitted to and in conduction with the conductive fitting members 6. As shown in FIG. 6 and FIG. 10, in another embodiment of the present application, the wiring structure further includes an adapting member, and the conductive connector 5 is in conduction with the conductive fitting member 6 through the adapting member. During assembly, the adapting member is fixed to the conductive fitting members 6 by plug-in fit, and then the second mounting member 4 with the adapting member is assembled with the conductive connectors 5 on the first mounting member 3. This assembly structure can avoid the unfixed position of the conductive fitting member 6 caused by the relative fixation of the conductive fitting member 6 with the second mounting member 4 through the external cable 2, and facilitate the alignment of the conductive connector 5 on the first mounting member 3 and the corresponding conductive fitting member 6 on the second mounting member 4.

The adapting member may have various types of structures. Specifically, as shown in FIG. 6 to FIG. 10, in an embodiment of the present application, the adapting member includes an adapting terminal 8 and a conductive adapter 9 embedded in the adapting terminal 8. The adapting terminal 8 is made of insulating material, and the conductive adapter 9 may be integrally or partially made of insulating material. Two ends of the conductive connector 5 are connected with the conductive connector 5 and the conductive fitting member 6 respectively, and the conductive connector 5 is in conduction with the conductive fitting member 6 through the conductive adapter 9.

Specifically, a pin is provided on one of the conductive adapter 9 and the conductive connector 5, a pin hole is defined on the other end of the conductive adapter 9 and the conductive connector 5, and the conductive adapter 9 is in conduction with the conductive connector 5 through plug-in fit between the pin and the pin hole. A pin is provided on one of the conductive adapter 9 and the conductive fitting member 6, a pin hole is defined on the other one of the conductive adapter 9 and the conductive fitting member 6, and the conductive adapter 9 is in conduction with the conductive fitting member 6 through plug-in fit between the pin and the pin hole.

In order to further optimize the above technical solutions, an anti-dropping position-limiting structure is provided between the conductive fitting member 6 and the conductive adapter 9. The anti-dropping position-limiting structure includes an elastic protrusion provided on one of the conductive fitting member 6 and the conductive adapter 9 and a position-limiting groove defined on the other one of the conductive fitting member 6 and the conductive adapter 9, and the elastic protrusion is fitted to the position-limiting groove when the conductive fitting member 6 is in plug-in fit with the conductive adapter 9, which ensures that the conductive fitting member 6 would not fall off under normal pulling without using a tool.

Certainly, the adapting member is not limited to the structure of the adapting terminal 8 and the conductive adapter 9. In another embodiment of the present application, the adapting member includes a contactor, two ends of the contactor are respectively provided with multiple adapting input ends for connecting with the conductive fitting members 6 and multiple adapting output ends for connecting with the conductive connectors 5, each adapting output end is electrically connected with at least one adapting input end, each adapting input end is pressed against and fixed to the corresponding conductive fitting member 6 by a rotary switch or a threaded fastener, and each adapting output end is pressed against and fixed to the corresponding conductive connector 5 by a rotary switch or a threaded fastener.

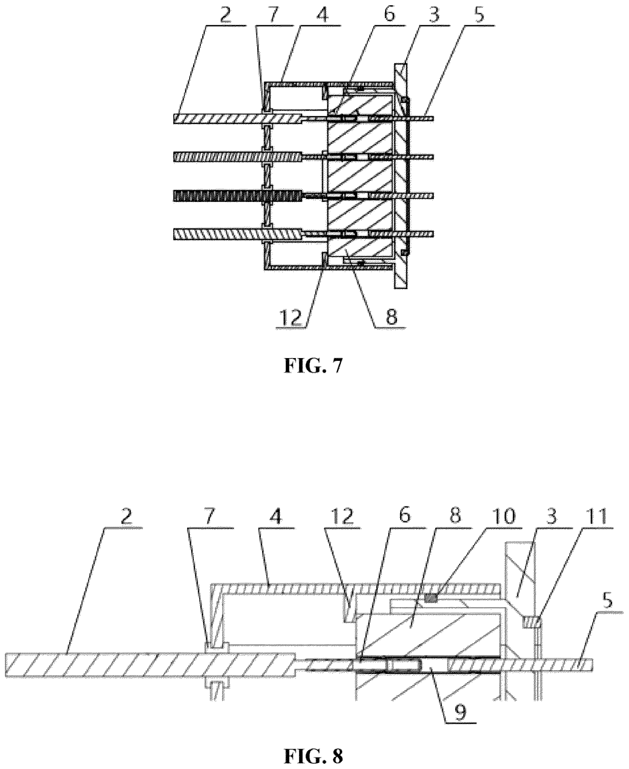

Preferably, the second mounting member 4 is provided with a position-limiting structure cooperating with the adapting member, and the position-limiting structure is configured to fix the adapting member to the second mounting member 4. As shown in FIG. 8 and FIG. 10, in an embodiment of the present application, the position-limiting structure includes a position-limiting stop 12 arranged inside the second mounting member 4, and the position-limiting stop 12 cooperates with the adapting member to fix the adapting member to the second mounting member 4 in a case that the first mounting member 3 is assembled with the second mounting member 4.

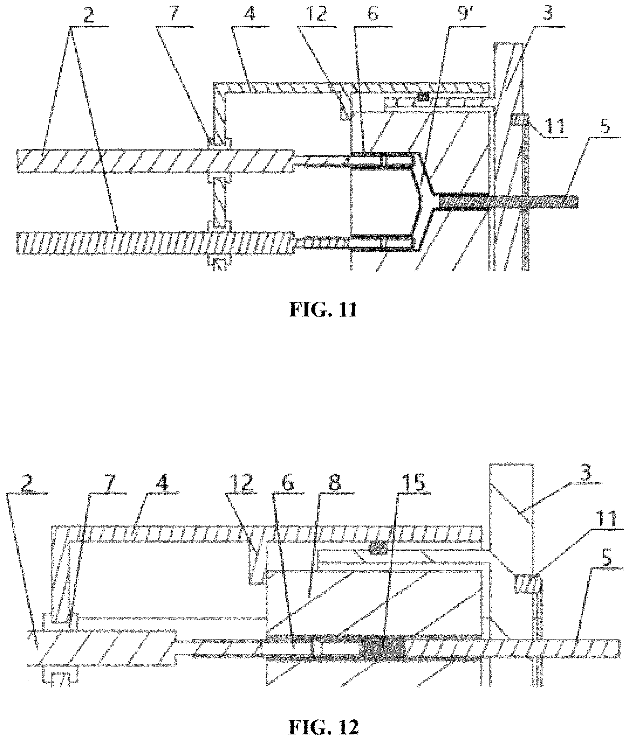

One-to-one connection or multiple-to-one connection may be realized between the conductive connectors 5 and the conductive fitting members 6 through the adapting member. As shown in FIG. 11, one adapting output end of the adapting member is correspondingly connected with multiple adapting input ends. In the embodiment as shown in the figure, one adapting output end of the adapting member 9' is connected with two adapting input ends, so that the adapting member 9' is of a Y-shaped structure. Certainly, the adapting member 9' with the Y-shaped structure is only a preferred embodiment of the present application. In fact, one adapting output end may be correspondingly connected with three, four or more adapting input ends, or multiple adapting output ends may be correspondingly connected with one adapting input end as required, which is not limited herein.

Preferably, the wiring structure further includes an overload-protection device, which includes but is not limited to a fuse 15. The overload-protection device may be arranged on the external cable 2. Alternatively, the overload-protection device may be connected between the external cable 2 and the conductive fitting member 6. Alternatively, the overload-protection device may be arranged in the adapting member, as shown in FIG. 12, the fuse 15 is arranged in the conductive adapter 9 and is located between the conductive connector 5 and the conductive fitting member 6. Alternatively, the overload-protection device may be arranged in the electrical cabinet 1 and connected with the corresponding conductive connector 5.

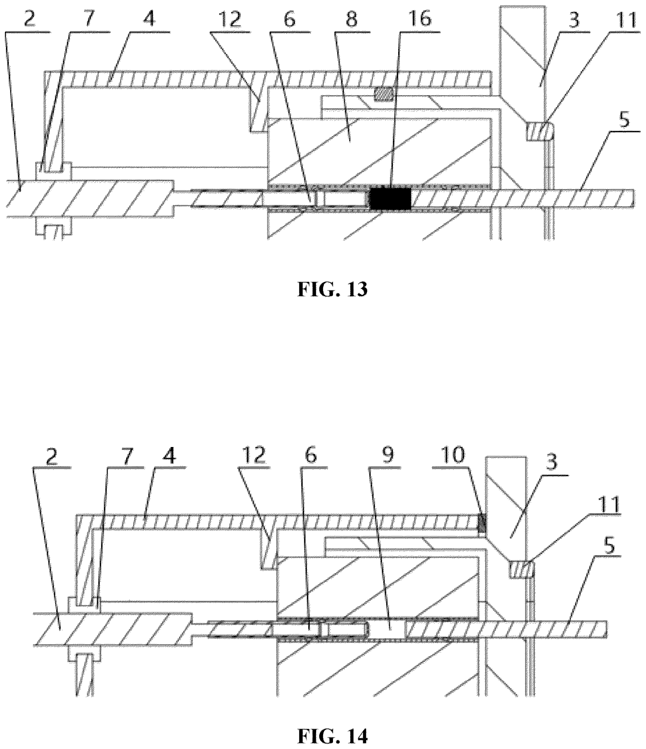

Preferably, the wiring structure further includes a detection device 16. The detection device 16 may be arranged on the external cable 2. Alternatively, the detection device 16 may be connected between the external cable 2 and the corresponding conductive fitting member 6. Alternatively, the detection device 16 may be arranged in the adapting member, as shown in FIG. 13, the detection device 16 is arranged in the conductive adapter 9 and is located between the conductive connector 5 and the conductive fitting member 6. Alternatively, the detection device 16 may be arranged in the electrical cabinet 1 and connected with the corresponding conductive connector 5.

Specifically, the detection device 16 includes at least one of a temperature sensor, a current sensor and a voltage sensor.

In order to further optimize the technical solution, the wiring structure further includes a weak current output module and a power input module which are connected with the detection device 16, the weak current output module is configured to output a signal acquired by the detection device 16, and the power input module is configured to supply power to the detection device 16.

Specifically, in an embodiment of the present application, the power input module includes a power circuit. The power circuit is connected between the external cable and the detection device 16 and directly takes power from the external cable 2 to supply power to the detection device 16. Certainly, in other embodiments, the power input module may include a battery and a circuit connecting the battery with the detection device 16.

Further, the wiring structure includes an integrated circuit board. The detection device 16, the weak current output module and the power input module are arranged on the integrated circuit board. The integrated circuit board is arranged at the external cable 2; or the integrated circuit board is arranged on the first mounting member 3 and is connected with the conductive connector 5; or the integrated circuit board is arranged in the electrical cabinet 1 and is connected with the conductive connector 5; or the integrated circuit board is arranged on the second mounting member 4 and is connected with the conductive fitting member 6.

Preferably, as shown in FIG. 6, in an embodiment of the present application, the first mounting member 3 includes a base which has a groove defined by an annular boss, and the multiple conductive connectors 5 are arranged in the groove. The second mounting member 4 includes a housing which is detachably and sealingly fitted to the base for connection, and the annular boss is covered in the housing. In this fitting structure, the housing and the annular boss of the base are fitted to each other, which increases the tightness of the connection between the first mounting member 3 and the second mounting member 4, and plays a guiding role during assembly. Certainly, the design of the shape of an inner wall of the housing and the annular boss can also achieve the fool-proofing function.

In order to improve the sealing performance between the first mounting member 3 and the second mounting member 4, a sealing structure is provided between an end surface of an opening end of the housing and the base as shown in FIG. 14, and/or, a sealing structure is provided between an inner wall of the housing and an outer wall of the annular boss, as shown in FIG. 8 and FIG. 10. The sealing structure includes at least one sealing ring 10. The sealing ring 10 may be an O-shaped ring, a lip-shaped ring, etc.. The sealing structure may be a labyrinth sealing structure or a combination of the labyrinth sealing structure and the sealing ring 10.

Preferably, as shown in FIG. 6, a sealing structure is provided on a surface, in contact with the electrical cabinet 1, of the base. The sealing structure includes at least one sealing ring 11. The sealing ring 11 may be an O-shaped ring, a lip-shaped ring, etc., so as to realize sealing between the base and the electrical cabinet 1.

The connection manner between the first mounting member 3 and the second mounting member 4 is described in detail hereinafter. The first mounting member 3 may be detachably connected with the second mounting member 4 by a snap-fit structure and/or a threaded fastener.

In an embodiment, the snap-fit structure between the first mounting member 3 and the second mounting member 4 includes multiple elastic hooks 13 and multiple hook grooves 14. The multiple elastic hooks 13 are uniformly provided at one of the first mounting member 3 and the second mounting member 4 circumferentially, the multiple hook grooves 14 are provided in one-to-one correspondence with the elastic hooks 13 and defined on the other one of the first mounting member 3 and the second mounting member 4, and the elastic hooks 13 cooperate with the hook grooves 14 to detachably connect the first mounting member 3 with the second mounting member 4.

As shown in FIG. 10, the elastic hooks 13 are provided on the first mounting member 3, and the hook grooves 14 are defined on the second mounting member 4. When the first mounting member 3 and the second mounting member 4 approach each other until the second mounting member 4 is in contact with the elastic hooks 13, the elastic hooks 13 are elastically deformed and gathered together under the action of inner walls of the hook grooves 14 of the second mounting member 4 (certainly, the elastic hooks 13 may be scattered from each other depending on mounting orientations of the elastic hooks 13). When the first mounting member 3 and the second mounting member 4 are fitted to each other in place, a hook-like structure at an end of the elastic hook 13 extends out from the hook groove 14, the inner wall of the hook groove 14 no longer forces the elastic hook 13 to deform elastically, and the elastic hook 13 returns to cooperate with an end face, away from the first mounting member 3, of the hook groove 14 under its own elasticity, so as to realize fitting between the first mounting member 3 and the second mounting member 4.

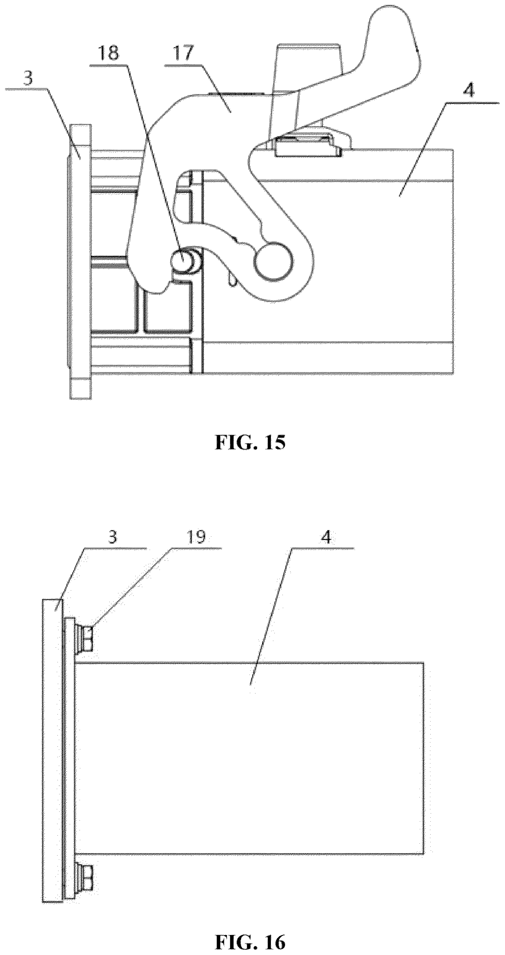

Certainly, the snap-fit structure is not limited to the above structure. As shown in FIG. 15, in another embodiment, the snap-fit structure includes a locking hook 17 and a locking pin 18. The locking hook 17 is rotatably arranged at one of the first mounting member 3 and the second mounting member 4. An elastic member is provided between the locking hook 17 and the one of the first mounting member 3 and the second mounting member 4 which is provided with the locking hook 17. The locking pin 18 is arranged on the other one of the first mounting member 3 and the second mounting member 4, and the locking hook 17 cooperates with the locking pin 18 under the action of the elastic member. The cooperation herein refers to that the locking hook 17 hooks the locking pin 18 to detachably connect the first mounting member 3 with the second mounting member 4. In the embodiment shown in FIG. 15, the locking hook 17 is provided on the second mounting member 4, and the locking pin 18 is provided on the first mounting member 3. One locking hook 17 may be arranged or multiple locking hooks 17 may be symmetrically arranged on the second mounting member 4, and the number and position of the locking pin 18 correspond to the number and position of the locking hook 17. During assembly, the user first pushes the locking hook 17 to rotate until an opening of the locking hook 17 faces the first mounting member 3. Then, the second mounting member 4 is aligned with the first mounting member 3 for assembly. When the second mounting member 4 is in plug-in fit with the first mounting member 3 in place, the locking hook 17 is released, and the locking hook 17 is reset under the action of the elastic member to cooperate with the locking pin 18.

In another embodiment, as shown in FIG. 16, locking pin 18 the threaded fastener includes multiple bolts 19, the first mounting member 3 is provided with multiple threaded holes, the second mounting member 4 is provided with multiple through holes, and the bolts 19 pass through the through holes and cooperate with the threaded holes to detachably connect the first mounting member 3 with the second mounting member 4.

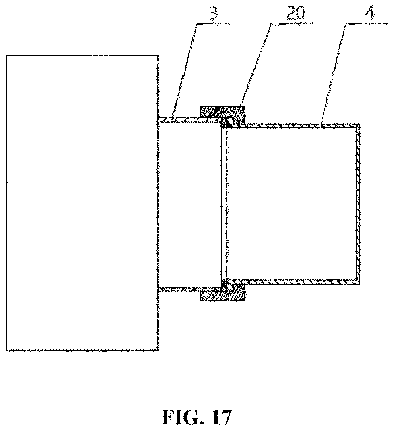

The threaded fastener is not limited to the above bolts 19. As shown in FIG. 17, the threaded fastener includes a threaded sleeve 20 which is rotatably sleeved on the second mounting member 4, an outer wall of the first mounting member 3 is provided with threads engaged with the threaded sleeve 20, and the first mounting member 3 is pressed against and fixed to the second mounting member 4 by threaded engagement between the threaded sleeve 20 and the first mounting member 3.

In the embodiment shown in FIG. 17, in order to facilitate sealing, at least one of fitting surfaces of the first mounting member 3 and the second mounting member 4 is provided with a sealing ring serving as a sealing structure.

Certainly, the snap-fit structure can be used in combination with the connecting structure of the threaded fastener to further increase the connecting strength between the first mounting member 3 and the second mounting member 4, so as to avoid detachment.

An electrical cabinet 1 is further provided according to an embodiment of the present application, and the electrical cabinet 1 is provided with the wiring structure described in the above embodiments. Since the wiring structure in the above embodiments is employed, the technical effects of the electrical cabinet 1 can be referred to the above embodiments.

The above embodiments in this specification are described in a progressive manner. Each of the embodiments is mainly focused on describing its differences from other embodiments, and references may be made among these embodiments with respect to the same or similar portions among these embodiments.

Based on the above description of the disclosed embodiments, those skilled in the art are capable of carrying out or using the present application. It is obvious for those skilled in the art to make many modifications to these embodiments. The general principle defined herein may be applied to other embodiments without departing from the scope of the present application. Therefore, the present application is not limited to the embodiments illustrated herein, but should be defined by the broadest scope consistent with the principle and novel features disclosed herein.

## Claims

1. A wiring structure, for connecting an internal device of an electrical cabinet with external cables, comprising:
a first mounting member configured to be arranged outside the electrical cabinet, wherein the first mounting member is provided with a plurality of conductive connectors configured to extend into the electrical cabinet to be connected with the internal device; and
a second mounting member configured to be detachably connected with the first mounting member, wherein a plurality of conductive fitting members are provided in the second mounting member and are connected with the external cables, the external cables are in slidable fit with the second mounting member in a sealed manner, the plurality of conductive fitting members are configured to be fitted to and in conduction with the plurality of conductive connectors in a case that the second mounting member is connected with the first mounting member.

2. The wiring structure according to claim 1, wherein one of each of the plurality of conductive connectors and the corresponding conductive fitting member is provided with a pin, the other one of the conductive connector and the corresponding conductive fitting member is provided with a pin hole, and the conductive connector is in conduction with the corresponding conductive fitting member through plug-in fit between the pin and the pin hole.

3. The wiring structure according to claim 1, further comprising an adapting member, wherein the plurality of conductive connectors are connected to and in conduction with the plurality of conductive fitting members through the adapting member.

4. The wiring structure according to claim 3, wherein the adapting member comprises an adapting terminal and a conductive adapter embedded in the adapting terminal, two ends of the conductive adapter are connected with the corresponding conductive connector and the corresponding conductive fitting member respectively, and the conductive connector is in conduction with the conductive fitting member through the conductive adapter.

5. The wiring structure according to claim 4, wherein
one of the conductive adapter and the conductive connector is provided with a pin, the other of the conductive adapter and the conductive connector is provided with a pin hole, and the conductive adapter is in conduction with the conductive connector through plug-in fit between the pin and the pin hole; and
one of the conductive adapter and the conductive fitting member is provided with another pin, the other of the conductive adapter and the conductive fitting member is provided with another pin hole, and the conductive adapter is in conduction with the conductive fitting member through plug-in fit between the another pin and the another pin hole.

6. The wiring structure according to claim 5, wherein an anti-dropping position-limiting structure is provided between the conductive fitting member and the conductive adapter, wherein the anti-dropping position-limiting structure comprises an elastic protrusion provided on one of the conductive fitting member and the conductive adapter and a position-limiting groove defined on the other of the conductive fitting member and the conductive adapter, and the elastic protrusion is fitted to the position-limiting groove when the conductive fitting member is in plug-in fit with the conductive adapter.

7. The wiring structure according to claim 3, wherein the adapting member comprises a contactor, two ends of the contactor are respectively provided with a plurality of adapting input ends for connecting with the conductive fitting members and a plurality of adapting output ends for connecting with the conductive connectors, each of the plurality of adapting output end is electrically connected with at least one of the plurality of adapting input ends, each of the plurality of adapting input ends is pressed against and fixed to the corresponding conductive fitting member by a rotary switch or a threaded fastener, and each of the plurality of adapting output ends is pressed against and fixed to the corresponding conductive connector by a rotary switch or a threaded fastener.

8. The wiring structure according to any one of claims 3 to 7, wherein the second mounting member is provided with a position-limiting structure cooperating with the adapting member.

9. The wiring structure according to any one of claims 3 to 7, wherein one adapting output end of the adapting member is correspondingly connected with a plurality of adapting input ends.

10. The wiring structure according to any one of claims 3 to 7, further comprising an overload-protection device, wherein
the overload-protection device is arranged on each of the external cables; or,
the overload-protection device is connected between the external cable and the corresponding conductive fitting member; or,
the overload-protection device is arranged in the adapting member; or,
the overload-protection device is arranged in the electrical cabinet and is connected with the corresponding conductive connector.

11. The wiring structure according to any one of claims 3 to 7, further comprising a detection device, wherein
the detection device is arranged on each of the external cables; or,
the detection device is connected between the external cable and the corresponding conductive fitting member; or,
the detection device is arranged in the adapting member; or,
the detection device is arranged in the electrical cabinet and is connected with the corresponding conductive connector.

12. The wiring structure according to claim 11, wherein the detection device comprises at least one of a temperature sensor, a current sensor and a voltage sensor.

13. The wiring structure according to claim 11, further comprising a weak current output module and a power input module which are connected with the detection device, the weak current output module is configured to output a signal acquired by the detection device, and the power input module is configured to supply power to the detection device.

14. The wiring structure according to claim 13, wherein the power input module comprises a power circuit which is connected between the external cable and the detection device.

15. The wiring structure according to claim 13 or 14, further comprising an integrated circuit board, wherein the detection device, the weak current output module and the power input module are arranged on the integrated circuit board; and wherein
the integrated circuit board is arranged at the external cable; or,
the integrated circuit board is arranged on the first mounting member and is connected with the conductive connector; or,
the integrated circuit board is arranged in the electrical cabinet and is connected with the conductive connector; or,
the integrated circuit board is arranged on the second mounting member and is connected with the conductive fitting member.

16. The wiring structure according to any one of claims 1 to 7 and 12 to 14, wherein the plurality of conductive connectors are connected with the plurality of conductive fitting members in one-to-one correspondence.

17. The wiring structure according to any one of claims 1 to 7 and 12 to 14, wherein each of the conductive connectors comprises a plurality of connection input ends and a connection output end, the plurality of connection input ends are connected with the connection output end, the plurality of connection input ends are in conduction with the corresponding conductive fitting member, and the connection output end extends into the electrical cabinet to be connected with the internal device.

18. The wiring structure according to any one of claims 1 to 7 and 12 to 14, wherein
the first mounting member comprises a base which has a groove defined by an annular boss, and the plurality of conductive connectors are arranged in the groove; and
the second mounting member comprises a housing which is detachably and sealingly fitted to the base for connection, and the annular boss is covered in the housing.

19. The wiring structure according to claim 18, wherein
a sealing structure is provided between an end surface of an opening end of the housing and the base; and/or,
a sealing structure is provided between an inner wall of the housing and an outer wall of the annular boss.

20. The wiring structure according to claim 18, wherein a sealing structure is provided on a surface, in contact with the electrical cabinet, of the base.

21. The wiring structure according to any one of claims 1 to 7, 12 to 14, 19 and 20, wherein the first mounting member is detachably connected with the second mounting member by a snap-fit structure and/or a threaded fastener.

22. The wiring structure according to claim 21, wherein the snap-fit structure comprises:
a plurality of elastic hooks, which are uniformly provided at one of the first mounting member and the second mounting member circumferentially; and
a plurality of hook grooves, which are provided in one-to-one correspondence with the elastic hooks and defined at the other of the first mounting member and the second mounting member; and wherein
the elastic hooks cooperate with the hook grooves to detachably connect the first mounting member with the second mounting member.

23. The wiring structure according to claim 21, wherein the snap-fit structure comprises:
a locking hook, which is rotatably arranged at one of the first mounting member and the second mounting member, wherein an elastic member is provided between the one of the first mounting member and the second mounting member which is provided with the locking hook and the locking hook; and
a locking pin, which is arranged on the other of the first mounting member and the second mounting member, wherein the locking hook cooperates with the locking pin under the action of the elastic member to detachably connect the first mounting member with the second mounting member.

24. The wiring structure according to claim 21, wherein the threaded fastener comprises a plurality of bolts, the first mounting member is provided with a plurality of threaded holes, the second mounting member is provided with a plurality of through holes, and the plurality of bolts pass through the plurality of through holes and cooperate with the plurality of threaded holes to detachably connect the first mounting member with the second mounting member.

25. The wiring structure according to claim 21, wherein the threaded fastener comprises a threaded sleeve which is rotatably sleeved on the second mounting member, an outer wall of the first mounting member is provided with threads engaged with the threaded sleeve, and the first mounting member is pressed against and fixed to the second mounting member by threaded engagement between the threaded sleeve and the first mounting member.

26. An electrical cabinet, provided with the wiring structure according to any one of claims 1 to 25.
